# FASCICULE DE BREVET EUROPEEN

(11) **EP 1 651 560 B1**
(45) Date de publication et mention de la délivrance du brevet: **19.11.2008**
(21) Numéro de dépôt: 04767683.8
(22) Date de dépôt: 15.07.2004
(51) Int. Cl.: B81B 3/00, H01L 21/20, H01L 21/762

(54) **Structure empilée et procédé pour la fabriquer**
Schichtstruktur und Herstellungsverfahren dafür
Stacked structure and production method thereof

(30) Priorité: 21.07.2003 FR 0308865
(43) Date de publication de la demande: 03.05.2006
(73) Titulaire: COMMISSARIAT A L'ENERGIE ATOMIQUE, 75015 Paris (FR)
(72) Inventeur: MORICEAU, Hubert, F-38120 Saint-Egreve (FR); ASPAR, Bernard, F-38140 Rives (FR); MARGAIL, Jacques, F-38700 La Tronche (FR)
(74) Mandataire: Bonnans, Arnaud
(86) Numéro de dépôt international: PCT/FR2004/001858
(87) Numéro de publication internationale: WO 2005/019094

(56) Documents cités:
- FR-A- 2 797 347
- US-A- 5 259 247
- US-A- 6 156 215
- US-A1- 2001 055 831
- US-A1- 2002 145 489
- US-B1- 6 198 159
- LIU X H ET AL: "Investigation of interface in silicon-on-insulator by fractal analysis" APPLIED SURFACE SCIENCE, 28 FEB. 2002, ELSEVIER, NETHERLANDS, vol. 187, no. 3, 28 février 2002 (2002-02-28), pages 187-191, XP002272808 ISSN: 0169-4332
- YEE Y ET AL: "Polysilicon surface-modification technique to reduce sticking of microstructures" SENSORS AND ACTUATORS A, ELSEVIER SEQUOIA S.A., LAUSANNE, CH, vol. 52, no. 1, 1 mars 1996 (1996-03-01), pages 145-150, XP004007044 ISSN: 0924-4247
- FUJITSUKA N.; SAKATA J.: 'A new processing technique to prevent stiction using silicon selective etching for SOI-MEMS' SENSORS AND ACTUATORS A vol. A97-98, 01 Avril 2002, ELSEVIER SEQUOIA S.A., LAUSANNE, CH, pages 716 - 719, XP004361671
- ASHURST W.R.; CARRARO C.; MABOUDIAN R.; FREY W.: 'Wafer level anti-stiction coatings for MEMS' SENSORS AND ACTUATORS A vol. 104, no. 3, 15 Mai 2003, ELSEVIER, SEQUOIA S.A., LAUSANNE, CH, pages 213 - 221, XP004423403

## Description

Le domaine général de l'invention est celui de la fabrication de microstructures à partir de substrats (« *wafer level* » en anglais), par exemple au moyen des techniques de microusinage ou de traitement chimique utilisées en microélectronique (dépôt et gravure de couches, photolithographie, et ainsi de suite).

L'invention concerne plus particulièrement certaines microstructures de type MEMS (initiales des mots anglais « *Micro-Electro-Mechanical Systems* », c'est à dire « Systèmes Electro-Mécaniques Microscopiques »), telles que divers détecteurs et actionneurs, qui sont obtenues par libération de parties mobiles (par exemple des membranes ou des masses sismiques).

Pour obtenir de telles microstructures, on peut utiliser par exemple au départ un matériau du type SOI (initiales des mots anglais « *Silicon On Insulafor* » signifiant Silicium sur Isolant), qui comprend habituellement une couche superficielle de silicium et d'une couche d'oxyde de silicium SiO₂ enterrée sous-jacente.

Il existe plusieurs moyens de fabriquer du matériau SOI. A cet égard, on pourra par exemple consulter l'ouvrage de Q.Y. Tong et U. Goesele intitulé « Semiconductor Wafer Bonding » (Science and Technology, ECS Series, John Wiley, New Jersey 1999). Cependant, la majorité des matériaux SOI est aujourd'hui fabriquée par la technique d'adhésion moléculaire. Par exemple, on colle par adhésion moléculaire deux plaques de silicium dont au moins une des deux plaques contient une couche d'oxyde de silicium en surface. La couche d'oxyde de silicium est habituellement réalisée par oxydation thermique. Ensuite on amincit une des deux plaques. On obtient ainsi une structure de type SOI.

Plusieurs techniques permettant d'obtenir une couche mince peuvent être utilisées (dans le cadre de la présente invention, on qualifiera une couche de « mince » si son épaisseur est inférieure à quelques dizaines de microns). Par exemple, une première technique est l'amincissement (mécanique par rectification et/ou lissage, et/ou chimique, et/ou mécano-chimique). Une deuxième technique est la fracture au niveau d'une zone fragile, cette zone fragile ayant été créée, avant ladite adhésion moléculaire, à une certaine profondeur dans une des deux plaques, par exemple par implantation d'une ou plusieurs espèces gazeuses : la demande de brevet FR-2 681 472 divulgue un tel procédé, qui est à présent connu sous le nom de procédé « Smart-Cut^{®} » (voir par exemple l'article de B. Aspar et al. intitulé « The Generic Nature of the Smart-Cut® Process for Thin-Film Transfer», dans Journal of Electronic Materials, vol. 30, n° 7, 2001). Ces procédés sont très bien adaptés pour l'obtention de couches minces superficielles de silicium, habituellement choisies inférieures à 2 µm.

A partir de ce matériau SOI, il est possible de réaliser des structures mécaniques mobiles ou déformables, par exemple par usinage du film supérieur de silicium et libération de la structure par attaque chimique de l'oxyde sous-jacent, tout ou partie ; on crée par exemple la structure mécanique en gravant avec un plasma la couche mince superficielle de silicium, et en gravant par attaque chimique avec de l'acide fluorhydrique HF la couche d'oxyde de silicium.

Dans le cadre de la présente invention, on dira qu'une couche faisant partie d'une structure empilée est une couche « sacrificielle » lorsque cette couche est apte à être ultérieurement éliminée, par exemple lors d'une utilisation de cette structure empilée pour fabriquer un composant comprenant une partie mobile ou déformable. La matière constituant une couche sacrificielle est donc différente, du point de vue chimique ou cristallographique, de la matière constituant les couches « non sacrificielles », c'est à dire destinées à être gardées après élimination de la couche sacrificielle. Par exemple dans le cas où la structure empilée est un matériau SOI, la couche d'oxyde de silicium joue le rôle de « couche sacrificielle », et les couches de silicium celui de « couches non sacrificielles ».

Ce mode de réalisation est relativement simple à mettre en oeuvre, et il permet d'obtenir toute une variété de microstructures.

Par exemple, on peut réaliser ainsi des capteurs de pression de bonne qualité.

Comme exemple d'une telle microstructure, on peut citer également l'accéléromètre divulgué dans le brevet FR 2 558 263. Cet accéléromètre comprend, au sein d'une couche mince, une première partie découpée dans cette couche mince et une seconde partie constituée par le reste de la couche mince, la première partie étant reliée à la seconde au moyen de poutrelles flexibles permettant à cette première partie, ou partie « sensible », de se déplacer avec une certaine amplitude dans le plan de la couche mince. Ce dispositif sert à mesurer les accélérations d'un système quelconque dont il est solidaire, au moyen d'une variation de capacité électrique causée par ledit déplacement.

On pourra trouver d'autres exemples détaillés de telles microstructures dans l'article de B. Diem et al., intitulé « SOI 'SIMOX'; from bulk to surface micromachining, a new age for silicon sensors and actuators », dans Sensors and Actuators, vol. A 46 - 47, pages 8 à 16 (1995).

Cependant, la fabrication de telles microstructures doit faire face au problème suivant. Lors de la réalisation de la structure, et en particulier au moment du séchage du liquide de rinçage après attaque chimique à l'acide fluorhydrique, les forces de capillarité entre les surfaces et le liquide sont très importantes et conduisent à des phénomènes de collage partiel ou total des structures libérées ; une autre cause de collage est, le cas échéant, le dépôt solide qui se produit au moment dudit séchage. Cela conduit par exemple, dans le cas de l'accéléromètre décrit ci-dessus, au collage des poutrelles avec le substrat constituant le fond de la cavité contenant le dispositif, ce qui empêche évidemment les poutrelles de se déplacer comme prévu sous l'effet des accélérations du système.

Les techniques de fabrication de structures SOI mentionnées ci-dessus conduisent à des interfaces (entre la couche superficielle de silicium et l'oxyde enterré, et entre l'oxyde enterré et le substrat) qui sont très peu « rugueuses ». Ce « problème du collage » est d'autant plus important que les structures SOI sont aujourd'hui réalisées avec un souci d'avoir des interfaces très lisses ; il est également d'autant plus gênant que l'épaisseur du film d'oxyde sera fine, et que les dimensions des structures à libérer seront grandes.

Afin d'éviter ces problèmes de collage indésirable, il est nécessaire de prendre d'importantes précautions, ce qui rend le procédé de libération complexe, onéreux et difficile à maîtriser. De plus, pour des raisons de fiabilité, on souhaite éviter que de tels collages indésirables des faces en regard au sein des composants MEMS ne se produisent après la mise en service de ces composants.

Un premier moyen connu pour empêcher ce collage consiste à réduire l'énergie de collage de la couche libérée et du substrat. Mais ces techniques utilisent des méthodes de préparation chimique des surfaces qui sont incompatibles avec les hautes températures habituellement requises pour les étapes ultérieures de fabrication des MEMS. Pour plus de détails, on pourra se référer à l'article de C.H. Mastrangelo intitulé « Suppression of Stiction in MEMs » (Actes du Séminaire de la Materials Research Society, vol. 605, 2000).

Un second moyen connu pour empêcher ce collage consiste à s'arranger pour que, lors du rapprochement de ces deux surfaces, l'aire de contact effectif soit faible.

Le document US2001055831 divulgue un tel procédé de fabrication qui comprend les étapes suivantes: formation de tampons de butée sur une première plaque, dépôt d'une couche sacrificièlle couvrant la première plaquette ainsi que les tampons de butée, collage d'une deuxième plaquette à la surface libre de la couche sacrificielle, élimination de la couche sacrificielle afin de réaliser une partie mobile d'un composant de type MEMS.

Un autre tel procédé a été divulgué dans le brevet FR 9 508 882. Ce procédé consiste à maintenir à distance la couche libérée et le substrat en gravant la couche sacrificielle intermédiaire de manière à créer des butées sur chacune des faces en regard de la couche libérée et du substrat.

Un autre tel procédé a été décrit dans l'article de R.L. Alley et al. intitulé « Surface Roughness Modification of Interfacial Contacts in Polysilicon Microstructures » (Actes de la 7ème Conférence Internationale sur les Détecteurs et Actionneurs à Semiconducteurs). Cet article propose un procédé d'élaboration de composants à parties mobiles incluant des étapes pour aboutir à un composant dont les faces libres en regard présentent une « rugosité » apte à éviter un collage indésirable entre lesdites faces (pour une définition statistique de la « rugosité, » on se référera à cet article ; on peut par exemple effectuer des mesures de rugosité avec un microscope à force atomique explorant des zones, par exemple, de 1 µm x 1 µm). Ce procédé consiste, pendant l'étape de libération chimique de la structure, à rendre rugueuses les surfaces concernées afin que l'aire de contact effectif soit limitée aux sommets des aspérités de ces surfaces. L'article de R.L. Alley *et al*. a essentiellement pour objet d'étudier comment la force de collage diminue quand la rugosité augmente.

Or le procédé décrit dans cet article a pour inconvénient qu'il ne permet pas de réaliser certains types de composants. Notamment, ce procédé prévoit le dépôt d'un film superficiel sur le substrat de la structure empilée ; or l'homme du métier sait que, selon les matériaux concernés par exemple, ce dépôt n'est pas toujours possible. Par exemple, ce procédé ne permet pas d'obtenir un film superficiel à libérer qui soit monocristallin si la matière de la couche sacrificielle est amorphe ; il ne permet pas non plus d'obtenir un film monocristallin, de silicium par exemple, sur une couche sacrificielle en matériau polymère en raison de l'incompatibilité entre la température de dépôt de ce film de silicium et les températures que peut habituellement supporter un polymère.

La présente invention concerne donc un procédé de fabrication d'une structure empilée, au besoin de grandes dimensions, le cas échéant sur toute la surface d'une plaquette ayant par exemple un diamètre de 200 mm, et permettant ultérieurement la réalisation de n'importe quel composant de type MEMS sans collage des structures mécaniques mobiles ou déformables. Ce procédé de fabrication doit pouvoir être applicable quelles que soient les caractéristiques desdits composants, notamment leur taille ou les matériaux utilisés, en particulier lorsque la couche superficielle devant être (au moins partiellement) libérée est monocristalline, ou ne peut être déposée simplement sur la structure empilée requise.

L'invention propose donc un procédé de fabrication d'une structure empilée, selon la revendication 1.

Ainsi, la mise en oeuvre du procédé selon l'invention fournit une structure empilée comprenant une couche sacrificielle située entre deux substrats, et dans laquelle au moins l'un des deux substrats est tel qu'une partie au moins de sa surface en contact avec ladite couche sacrificielle est « structurée ». Dans le cadre de l'invention, on dira qu'une surface est « structurée » lorsqu'elle se trouve être essentiellement incapable de se coller à un autre substrat prédéterminé, Une surface peut par exemple être structurée du fait de la nature physico-chimique de cette surface, ou d'un revêtement appliqué sur cette surface ; une surface peut également être structurée en raison d'une rugosité supérieure à un seuil prédéterminé, par exemple égal à 0,2 nm RMS environ.

En partant de la structure empilée ainsi obtenue, on élimine une partie de la couche sacrificielle intermédiaire entre les deux plaques, et obtenient deux surfaces en regard dont l'une au moins présente une structuration appropriée. On évite de la sorte que ces deux surfaces ne se collent l'une à l'autre suite à un rapprochement entre les deux substrats.

On notera que, selon l'invention, la réalisation de surface(s) structurée(s) a lieu avant ou pendant la fabrication de la structure empilée, et donc de façon indépendante de la fabrication d'un composant de type MEMS.

Grâce à l'invention, on peut avantageusement choisir, pour constituer la structure empilée, tout ensemble de matériaux pouvant être ultérieurement utiles à la réalisation d'un composant MEMS. Par exemple, on pourra obtenir un empilement comprenant une couche mince de silicium sur une couche sacrificielle en polymère, ou une couche mince de silicium monocristallin sur une couche sacrificielle en oxyde de silicium. On notera également que le procédé selon l'invention n'impose aucune limitation sur les dimensions latérales de la structure empilée obtenue.

Selon des caractéristiques particulières de l'invention, on réalise en outre, avant ladite étape c), un lissage de la surface libre d'une couche sacrificielle ou, le cas échéant, des deux couches sacrificielles, et/ou, le cas échéant, de la surface libre de l'une desdites plaques.

Grâce à ces dispositions, on facilite le collage subséquent (étape c)). Ce collage pourra par exemple être un collage moléculaire, ou bien un collage utilisant une colle sacrificielle, c'est à dire une colle apte à être ultérieurement éliminée, par exemple lors d'une utilisation de ladite structure empilée pour fabriquer un composant comprenant une partie mobile ou déformable. De plus, le collage de l'étape c) pourra être « assisté » par exemple par des moyens mécaniques et/ou par un traitement plasma et/ou thermique, ces opérations étant réalisées pendant ou après ce collage, sous atmosphère spécifique ou à l'air libre.

Grâce à ces dispositions, on peut, notamment, consolider les diverses interfaces et/ou les rendre compatibles avec les futures étapes de réalisation des composants MEMS. On peut également ainsi rendre adhérentes deux surfaces rugueuses qui ne se colleraient pas l'une à l'autre spontanément.

Selon encore d'autres caractéristiques particulières de l'invention, suite à l'étape c), on amincit au moins une des deux plaques.

Grâce à ces dispositions, on pourra par exemple réaliser dans le film mince ainsi obtenu les parties d'un composant de type MEMS qui deviendront mobiles après élimination de la couche sacrificielle située au contact de ces parties.

Les deux plaques ainsi que la couche sacrificielle peuvent, bien entendu, être ou simples ou composites, c'est à dire formées elles-mêmes d'un empilement de couches en divers matériaux. La structure empilée ainsi obtenue peut avantageusement être de type SOI.

Par exemple, la première plaque, de même que la seconde plaque, peut être faite de silicium, ou d'un semi-conducteur autre que le silicium, par exemple SiC, GaN, ou InP, ou encore d'un matériau non semi-conducteur, tel que LiNbO₃, LiTaO₃, un verre, une silice fondue, ou un matériau supraconducteur. La première plaque, de même que la seconde plaque, peut également être une combinaison quelconque de ces matériaux, en particulier un empilement Si monocristallin/Si polycristallin, ou SiC/Si, ou InP/Si, ou SiC monocristallin/SiC polycristallin, ou encore SiC/SiO₂/SiC polycristallin. La matière constituant la couche sacrificielle réalisée sur la première plaque et/ou la matière constituant la couche sacrificielle réalisée sur la seconde plaque peut être, par exemple, de l'oxyde de silicium ou un matériau polymère.

Selon des caractéristiques particulières, au moins une desdites plaques présente initialement une couche superficielle. En particulier, cette couche superficielle peut avoir pour effet de structurer la surface de la plaque sur laquelle elle repose, en raison de la nature physico-chimique de cette couche superficielle.

Les deux substrats ainsi que la couche sacrificielle peuvent, bien entendu, être ou simples ou composites, c'est à dire formés eux-mêmes d'un empilement de couches en divers matériaux. La structure empilée ainsi obtenue peut en particulier être de type SOI.

Par exemple, le premier substrat, de même que le second substrat, peut être fait de silicium, ou d'un semi-conducteur autre que le silicium, par exemple SiC, GaN, ou InP, ou encore d'un matériau non semi-conducteur, tel que LiNbO₃, LiTaO₃, un verre, une silice fondue, ou un matériau supraconducteur. Le premier substrat, de même que le second substrat, peut également être une combinaison quelconque de ces matériaux, en particulier un empilement Si monocristallin/Si polycristallin, ou SiC/Si, ou InP/Si, ou SiC monocristallin/SiC polycristallin, ou encore SiC/SiO₂/SiC polycristallin. La matière constituant la couche sacrificielle peut être, par exemple, de l'oxyde de silicium ou un matériau polymère.

Selon d'autres caractéristiques particulières de l'invention, l'un au moins des deux substrats est une couche mince.

Les avantages offerts par ces matériaux sont essentiellement les mêmes que ceux offerts par les procédés de fabrication correspondants.

D'autres aspects et avantages de l'invention apparaîtront à la lecture de la description détaillée, que l'on trouvera ci-dessous, de modes particuliers de réalisation donnés à titre d'exemples non limitatifs. Cette description se réfère aux dessins annexés, dans lesquels :
- la figure 1 représente une plaque de silicium avant la mise en oeuvre de l'invention.
- la figure 2 représente la même plaque de silicium après application d'une première étape d'un procédé de fabrication selon un mode de réalisation de l'invention,
- la figure 3 représente une deuxième étape de ce procédé,
- la figure 4 représente une troisième étape de ce procédé,
- la figure 5 représente une quatrième étape de ce procédé, et
- la figure 6 représente une cinquième étape de ce procédé.

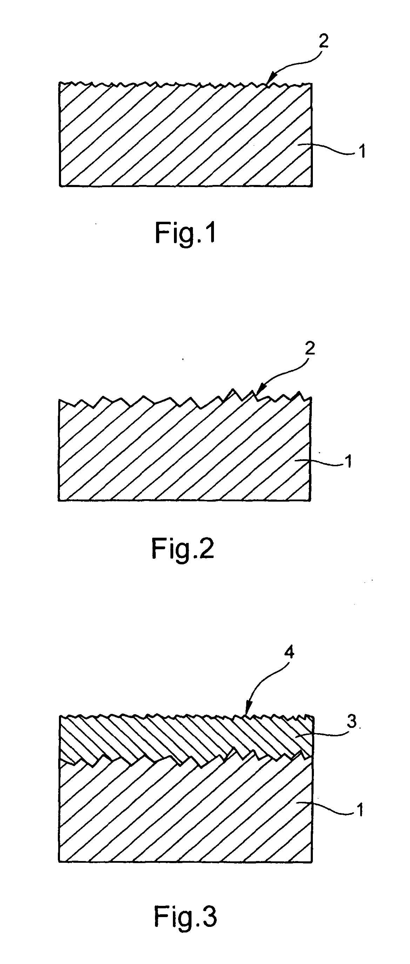

On prend tout d'abord une plaque de silicium standard 1 dont la surface 2 présente une rugosité *r*₂ qui est, habituellement, de l'ordre de 0,1 nm (**figure 1**).

On « structure » ensuite cette surface 2 (**figure 2**), par exemple en créant une rugosité *r*'₂ à la surface 2 de la plaque 1. De préférence, on créera une rugosité *r*'₂ dans la gamme de 0,2 nm à quelques micromètres. La rugosité à choisir dépend notamment, par exemple, de l'épaisseur de la couche intermédiaire sacrificielle, des paramètres géométriques du futur composant à parties mobiles visé, et des contraintes dans le film superficiel. L'homme du métier saura déterminer la rugosité à utiliser pour éviter tout collage indésirable au sein de ce composant.

Pour produire cette rugosité à la surface du silicium, on peut, par exemple, effectuer une ou plusieurs attaques par un mélange de type RCA SC1 (H₂O: NH₄OH: H₂O₂ 6:1 :1 à 80°C), et/ou utiliser d'autres procédés de gravure chimique humide (par exemple en utilisant une solution de TMAH ou de KOH), et/ou utiliser des procédés de gravure sèche (telle que la pulvérisation ionique réactive ou non réactive). Parmi les techniques permettant de produire cette rugosité, on citera en particulier :
- la technique de réalisation du silicium « noir », telle que décrite par exemple dans l'article de M. Schnell intitulé « Plasma Surface Texturization for Multicrystalline Silicon Solar Cells » (IEEE, XXVIIIème Conférence Photovoltaïque),
- les techniques « mécaniques », par exemple de sablage ou de rodage de surface (« *grinding* » en anglais),
- les techniques de « fracture » dans des matériaux cristallins laissant des substrats rugueux après fracture, et telles qu'utilisées par exemple dans le procédé Smart-Cut^{®} (comprenant une implantation d'espèces et une fracture), ou dans le procédé Eltran^{®} de la société CANON (comprenant l'obtention de silicium poreux et une fracture dans la zone poreuse),
- les techniques, bien connues de l'homme du métier, de gravure chimique pour obtenir des matériaux poreux, par exemple celles appliquées au silicium, et
- les techniques de dépôt, notamment un dépôt de nitrure de silicium Si₃N₄ par PECVD (on notera à cet égard que le dépôt par PECVD est plus rugueux que le dépôt par LPCVD).

Au cours d'une deuxième étape, on réalise (**figure 3**), à la surface de cette plaque 1, une couche sacrificielle 3.

La couche 3 peut par exemple être en oxyde de silicium. Dans ce cas, cette couche 3 peut être obtenue par oxydation thermique en atmosphère sèche ou humide, ou par dépôt (LPCVD, PECVD, ou toute autre méthode adaptée). La rugosité *r*₄ à la surface 4 de cette couche 3 peut être du même ordre de grandeur que la rugosité initiale de la plaque 1, ou supérieure (il est connu d'augmenter la rugosité en déposant des films successifs, la rugosité croissant avec le nombre de films déposés et leur épaisseur), ou bien réduite au moyen, par exemple, du dépôt d'un oxyde de lissage (non représenté) réalisé à basse température et dont le fluage en surface peut être provoqué, par exemple, par un traitement thermique adapté.

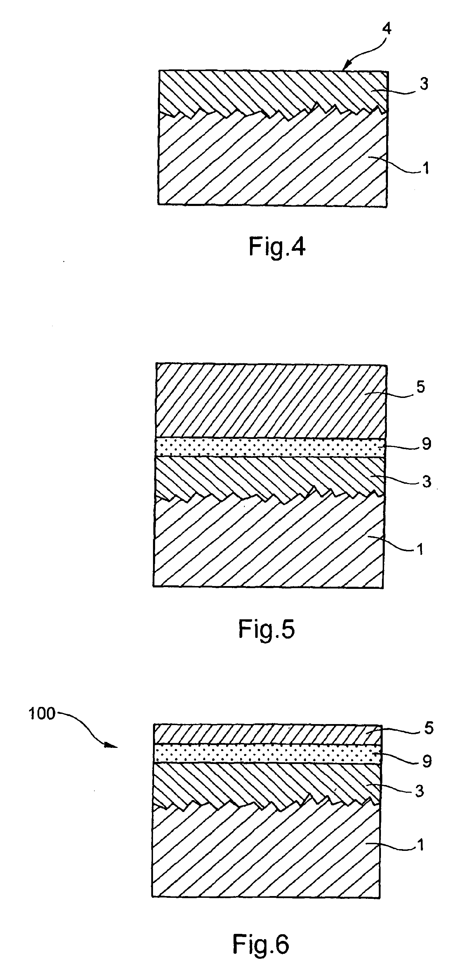

Cependant, dans certains cas, on peut vouloir adapter cette rugosité présentée par la surface 4 de la couche 3, de manière à faciliter l'étape suivante de collage aboutissant à la structure empilée selon l'invention. Pour cela, on peut par exemple obtenir une rugosité *r*'₄ un peu inférieure en réalisant, au cours d'une troisième étape (**figure 4**), un lissage de surface, par exemple par un léger polissage mécano-chimique et/ou par un traitement thermique sous une atmosphère spécifique et/ou par dépôt d'une couche de lissage (non représentée).

Au cours d'une quatrième étape (**figure 5**), on prend une seconde plaque 5, par exemple en silicium polycristallin (pouvant d'ailleurs éventuellement présenter en surface une couche 9 d'une autre matière, par exemple en silicium monocristallin ou en SiC), que l'on colle sur la couche 3, de préférence par adhésion moléculaire. Le collage peut également être réalisé au moyen d'un type de colle sacrificielle, c'est à dire pouvant être sélectivement retiré, par exemple un polymère photosensible.

Dans le cas d'une rugosité de surface incompatible avec un collage moléculaire spontané des parties à assembler pour former la structure empilée selon l'invention, on peut avantageusement utiliser une « assistance de collage », en premier lieu en mettant les surfaces en contact, le cas échéant après application d'un traitement par plasma de ces surfaces, puis en appliquant une contrainte mécanique et/ou un traitement thermique sur la structure empilée, sous atmosphère spécifique ou à l'air libre.

Un traitement thermique, appliqué pendant ou après le collage, permet de surcroît de consolider les diverses interfaces et/ou de les rendre compatibles avec les futures étapes de réalisation des composants MEMS.

Enfin, au cours d'une cinquième étape facultative, on peut amincir au moins une des deux plaques 1 et/ou 5 (la plaque 5 sur la figure 6), de façon à obtenir une structure empilée 100, par exemple de type SOI. L'amincissement peut être réalisé selon l'une quelconque des méthodes connues, telles que celles décrites en introduction.

On notera qu'il est parfaitement possible, selon une variante de l'invention, de placer des étapes du procédé de réalisation de la microstructure, par exemple la gravure dans la couche sacrificielle des zones en contact avec les parties mobiles, au milieu des étapes que l'on vient de décrire, par exemple avant l'étape de collage. Dans ce cas, les parties mobiles pourront éventuellement aussi être définies avant l'étape de collage dans la plaque ultérieurement amincie ; après le collage et l'amincissement de la plaque comprenant les parties mobiles, on pourra appliquer un traitement thermique de renforcement de l'interface de collage de la structure empilée sans contrainte de pression (lesdites zones sous-jacentes aux parties mobiles débouchant en surface).

Le mode de réalisation décrit ci-dessus peut être modifié, ou généralisé, de diverses manières. En particulier, le procédé peut concerner tout ou partie seulement de la surface d'une au moins des plaques ou d'un des films traités. Par exemple, on peut obtenir une structuration prédéterminée sur une zone localisée en utilisant un procédé de lithographie.

Comme on l'a mentionné plus haut, la « structuration » d'une surface donnée peut être obtenue sans nécessairement rendre cette surface rugueuse. Cependant, les examples sans surface rugueuse ne font pas partie de la présente invention.

Par exemple, lorsque l'autre substrat est en silicium, on pourra traiter la surface à structurer par nitruration.

Comme autre exemple, on pourra déposer sur la surface à structurer une couche d'un matériau « anti-collage », c'est à dire dont la nature physico-chimique est telle qu'elle s'oppose à tout collage ultérieur indésirable (naturellement, on peut éventuellement combiner les techniques de création de rugosité et de traitement de surface ou de réalisation d'une couche « anti-collage »).

On peut ainsi, initialement, déposer une couche superficielle 6 (non représentée), par exemple en Si₃N₄, sur une première plaque 1 de rugosité quelconque. On peut créer alors à la surface 2 de cette couche superficielle 6, comme expliqué précédemment, une rugosité *r*'₂, par exemple du fait de la conformation par dépôt sur une surface rugueuse. Mais on peut aussi, au lieu de cette création de rugosité ou en supplément, préparer la surface de cette couche superficielle 6 de manière à la rendre incompatible avec un collage indésirable avec le substrat destiné à se trouver en regard de la couche superficielle 6 ; on pourra par exemple, selon des procédés connus, rendre hydrophobe la surface d'une couche superficielle 6 en Si₃N₄ ; d'autres matériaux que le nitrure de silicium Si₃N₄ peuvent être utilisés ici, tels que le diamant, ou Al₂O₃ ou encore ZrO₂.

On dépose ensuite sur la couche superficielle 6 la couche sacrificielle 3 qui est, comme expliqué ci-dessus, adaptée au collage, par exemple moléculaire, avec la plaque 5 (qui est en silicium dans ce mode de réalisation), éventuellement après une étape de planarisation au moyen d'un polissage mécano-chimique ou un traitement thermique. Au besoin, le collage pourra être « assisté » comme expliqué ci-dessus. Lors de la réalisation du composant à structure mobile, l'attaque sélective de la couche 3 permettra de rendre libre la surface structurée de la couche superficielle 6 : au cours de cette attaque sélective, par exemple utilisant de l'acide fluorhydrique, la matière utilisée pour la couche sacrificielle 3, par exemple l'oxyde de silicium SiO₂, sera attaquée, alors que celle utilisée pour la couche superficielle 6, par exemple le nitrure de silicium Si₃N₄, ne le sera pas.

On a décrit ci-dessus des modes de réalisation dans lesquels seule la surface 2 de la première plaque 1 a été structurée ; mais il est clair que, dans le cadre de l'invention, on peut tout aussi bien, en plus ou à la place, structurer la surface 7 (non représentée) de la seconde plaque 5 (cette dernière comprenant éventuellement une couche superficielle 9, comme décrit ci-dessus).

Par ailleurs, dans les modes de réalisation décrits ci-dessus, on a réalisé une couche sacrificielle 3 seulement sur la première plaque 1 ; mais il est clair que, dans le cadre de l'invention, on peut tout aussi bien, en plus ou à la place, réaliser une couche sacrificielle 8 (non représentée) sur la seconde plaque 5. On procède ensuite au collage des deux plaques comme décrit ci-dessus, après, éventuellement, un lissage de la surface 10 (non représentée) de cette couche sacrificielle 8.

Il est clair que l'on peut, par exemple par dépôt localisé ou par gravure, réaliser une couche sacrificielle qui n'est pas continue ; cela permet de définir dans la structure empilée des zones déjà évidées.

Les procédés décrits ci-dessus peuvent aussi s'appliquer à toute structure comportant une couche mince adhérant à une couche enterrée à sacrifier localement, par exemple d'oxyde de silicium, cette dernière reposant sur un support pouvant être autre que du silicium. Selon les besoins de l'application envisagée, l'homme du métier pourra associer plusieurs des procédés décrits ici pour la réalisation de structures empilées spécifiques selon l'invention.

On notera pour terminer que la structuration de surface requise par l'invention n'est pas nécessairement homogène sur toute l'étendue des surfaces concernées : pour certaines applications, il peut par exemple être avantageux de réaliser une surface dont la structuration est répartie aléatoirement, ou bien respecte une certaine distribution à la surface d'une des plaques.

## Revendications

1. Procédé de fabrication d'une structure empilée, comprenant les étapes suivantes dans cet ordre :
a) traitement d'au moins une partie d'une première plaque (1) de sorte que la surface (2) de cette partie présente une rugosité telle que cette surface est incapable de se coller à une surface d'une seconde plaque (5),
b) réalisation d'une couche sacrificielle (3) sur une partie au moins de la surface (2) de la première plaque (1) et/ou de la surface de la seconde plaque (5),
c) collage des deux plaques (1; 5) entre elles,
et comprenant l'étape suivante :
d) élimination d'une partie au moins de la couche sacrificielle (3) de manière à mettre en regard une partie au moins de la partie traitée et la seconde plaque (5).

2. Procédé selon la revendication 1, **caractérisé en ce que** ladite rugosité est supérieure à 0,2 nm RMS environ.

3. Procédé selon l'une quelconque des revendications précédentes, **caractérisé en ce qu'**au moins une desdites plaques (1; 5) présente initialement une couche superficielle (6; 9).

4. Procédé selon la revendication 3, **caractérisé en ce que** ladite couche superficielle (6; 9) est monocristalline.

5. Procédé selon la revendication 3 ou la revendication 4, **caractérisé en ce que** ladite couche superficielle (6; 9) est en silicium.

6. Procédé selon la revendication 3, **caractérisé en ce que** ladite couche superficielle (6; 9) a pour effet de structurer la surface (2) de la partie traitée en raison de la nature physico-chimique de cette couche superficielle (6 ; 9).

7. Procédé selon la revendication 6, **caractérisé en ce que** ladite couche superficielle (6; 9) est en nitrure de silicium.

8. Procédé selon l'une quelconque des revendications précédentes, **caractérisé en ce que** l'on réalise en outre, avant ladite étape c), un lissage de la surface libre (4; 10) de la couche sacrificielle (3; 8), et/ou de la surface libre de l'une desdites plaques (1; 5).

9. Procédé selon l'une quelconque des revendications 1 à 8, **caractérisé en ce que** le collage de ladite étape c) est un collage moléculaire.

10. Procédé selon l'une quelconque des revendications 1 à 8, **caractérisé en ce que** le collage de ladite étape c) utilise une colle sacrificielle.

11. Procédé selon l'une quelconque des revendications précédentes, **caractérisé en ce que** le collage de ladite étape c) est assisté par des moyens mécaniques et/ou par un traitement plasma et/ou thermique, ces opérations étant réalisées pendant ou après ce collage, sous atmosphère spécifique ou à l'air libre.

12. Procédé selon l'une quelconque des revendications précédentes, **caractérisé en ce que,** suite à ladite étape c), on amincit au moins une des deux plaques (1) et/ou (5).

13. Procédé selon l'une quelconque des revendications précédentes, **caractérisé en ce que** la partie massive d'au moins une des plaques (1; 5) est faite d'une matière semi-conductrice.

14. Procédé selon la revendication 13, **caractérisé en ce que** ladite partie massive est en silicium.

15. Procédé selon l'une quelconque des revendications 1 à 14, **caractérisé en ce que** la couche sacrificielle (3; 8) est en oxyde de silicium.

16. Procédé selon l'une quelconque des revendications 1 à 14, **caractérisé en ce que** la matière constituant la couche sacrificielle (3 ; 8) est un polymère.

17. Procédé selon l'une des revendications 1 à 16, dans lequel l'étape d) est une étape de réalisation d'un composant de type MEMS.

## Claims

1. Method of fabricating a stacked structure, comprising the following steps in this order:
a) treatment of at least a portion of a first plate (1) so that the surface (2) of this portion has a roughness such that this surface cannot bond to a surface of a second plate (5),
b) production of a sacrificial layer (3) on at least a portion of the surface (2) of the first plate (1) and/or the surface of the second plate (5),
c) bonding together of the two plates (1; 5),
and comprising the following step:
d) elimination of at least a portion of the sacrificial layer (3) in such a way that at least a portion of the treated portion is opposite the second plate (5).

2. Method according to claim 1, **characterised in that** said roughness is greater than approximately 0.2 nm RMS.

3. Method according to any one of the preceding claims, **characterised in that** at least one of said plates (1; 5) initially has a surface layer (6; 9).

4. Method according to claim 3, **characterised in that** said surface layer (6; 9) is monocrystalline.

5. Method according to claim 3 or claim 4,
**characterised in that** said surface layer (6; 9) is of silicon.

6. Method according to claim 3, **characterised in that** said surface layer (6; 9) has the effect of structuring the surface (2) of the treated portion because of the physical-chemical nature of that surface layer (6; 9).

7. Method according to claim 6, **characterised in that** said surface layer (6; 9) is of silicon nitride.

8. Method according to any one of the preceding claims, **characterised in that** the free surface (4; 10) of the sacrificial layer (3; 8) and/or the free surface of one of said plates (1; 5) is smoothed before said step c).

9. Method according to any one of claims 1 to 8, **characterised in that** the bonding of said step c) is molecular bonding.

10. Method according to any one of claims 1 to 8, **characterised in that** the bonding of said step c) uses a sacrificial bonding agent.

11. Method according to any one of the preceding claims, **characterised in that** the bonding of said step c) is assisted by mechanical means and/or plasma treatment and/or thermal treatment, these operations being carried out during or after bonding, in a special atmosphere or in the open air.

12. Method according to any one of the preceding claims, **characterised in that** at least one of the two plates (1) and/or (5) is thinned after said step c).

13. Method according to any one of the preceding claims, **characterised in that** the massive portion of at least one of the plates (1; 5) consists of a semiconductor material.

14. Method according to claim 13, **characterised in that** said massive portion consists of silicon.

15. Method according to any one of claims 1 to 14,
**characterised in that** the sacrificial layer (3; 8) consists of silicon oxide.

16. Method according to any one of claims 1 to 14, **characterised in that** said material constituting the sacrificial layer (3; 8) is a polymer.

17. Method according to any of claims 1 to 16, in which step d) is a step for producing an MEMS type component.

## Patentansprüche

1. Verfahren zum Herstellen einer Schichtstruktur, das die folgenden Schritte in dieser Reihenfolge enthält:
a) Behandeln wenigstens eines Teils einer ersten Platte (1) in der Weise, dass die Oberfläche (2) dieses Teils eine Rauheit aufweist, derart, dass diese Oberfläche nicht an einer Oberfläche einer zweiten Platte (5) haften kann,
b) Verwirklichen einer Opferschicht (3) wenigstens auf einem Teil der Oberfläche (2) der ersten Platte (1) und/oder der Oberfläche der zweiten Platte (5),
c) Verkleben der zwei Platten (1; 5) miteinander, wobei das Verfahren den folgenden Schritt enthält:
d) Entfernen wenigstens eines Teils der Opferschicht (3) in der Weise, dass wenigstens ein Teil des behandelten Teils und die zweite Platte (5) sich einander gegenüber befinden.

2. Verfahren nach Anspruch 1, **dadurch gekennzeichnet, dass** die Rauheit größer als etwa 0,2 nm RMS ist.

3. Verfahren nach einem der vorhergehenden Ansprüche, **dadurch gekennzeichnet, dass** wenigstens eine der Platten (1; 5) zunächst eine Oberflächenschicht (6; 9) aufweist.

4. Verfahren nach Anspruch 3, **dadurch gekennzeichnet, dass** die Oberflächenschicht (6; 9) monokristallin ist.

5. Verfahren nach Anspruch 3 oder Anspruch 4, **dadurch gekennzeichnet, dass** die Oberflächenschicht (6; 9) aus Silicium besteht.

6. Verfahren nach Anspruch 3, **dadurch gekennzeichnet, dass** die Oberflächenschicht (6; 9) die Wirkung hat, die Oberfläche (2) des behandelten Teils aufgrund der physikalisch-chemischen Natur dieser Oberflächenschicht (6; 9) zu strukturieren.

7. Verfahren nach Anspruch 6, **dadurch gekennzeichnet, dass** die Oberflächenschicht (6; 9) aus Siliciumnitrid besteht.

8. Verfahren nach einem der vorhergehenden Ansprüche, **dadurch gekennzeichnet, dass** außerdem vor dem Schritt c) ein Glätten der freien Oberfläche (4; 10) der Opferschicht (3; 8) und/oder der freien Oberfläche einer der Platten (1; 5) ausgeführt wird.

9. Verfahren nach einem der Ansprüche 1 bis 8, **dadurch gekennzeichnet, dass** das Kleben des Schrittes c) ein molekulares Kleben ist.

10. Verfahren nach einem der Ansprüche 1 bis 8, **dadurch gekennzeichnet, dass** das Kleben des Schrittes c) einen Opferklebstoff verwendet.

11. Verfahren nach einem der vorhergehenden Ansprüche, **dadurch gekennzeichnet, dass** das Kleben des Schrittes c) durch mechanische Mittel und/oder durch eine Plasmabehandlung und/oder eine Wärmebehandlung unterstützt wird, wobei diese Operationen während oder nach diesem Kleben in einer bestimmten Atmosphäre oder im Freien ausgeführt werden.

12. Verfahren nach einem der vorhergehenden Ansprüche, **dadurch gekennzeichnet, dass** nach dem Schritt c) wenigstens eine der Platten (1) und/oder (5) dünn gemacht wird.

13. Verfahren nach einem der vorhergehenden Ansprüche, **dadurch gekennzeichnet, dass** der massive Teil wenigstens einer der Platten (1; 5) aus einem Halbleitermaterial hergestellt ist.

14. Verfahren nach Anspruch 13, **dadurch gekennzeichnet, dass** der massive Teil aus Silicium besteht.

15. Verfahren nach einem der Ansprüche 1 bis 14, **dadurch gekennzeichnet, dass** die Opferschicht (3; 8) aus Siliciumoxid besteht.

16. Verfahren nach einem der Ansprüche 1 bis 14,
**dadurch gekennzeichnet, dass** das Material, das die Opferschicht (3; 8) bildet, ein Polymer ist.

17. Verfahren nach einem der Ansprüche 1 bis 16, wobei der Schritt d) ein Schritt zum Verwirklichen einer Komponente des MEMS-Typs ist.
